# EUROPEAN PATENT APPLICATION

(11) **EP 3 843 131 A1**
(43) Date of publication of application: **30.06.2021**
(21) Application number: 20197789.9
(22) Date of filing: 23.09.2020
(51) Int. Cl.: H01L 21/8234, H01L 27/088, H01L 29/06, H01L 29/775, H01L 21/762

(54) **GATE-ALL-AROUND INTEGRATED CIRCUIT STRUCTURES HAVING LOW ASPECT RATIO ISOLATION STRUCTURES AND SUBFINS**

(30) Priority: 26.12.2019 US 201916727336
(71) Applicant: INTEL Corporation, Santa Clara, CA 95054 (US)
(72) Inventor: GUHA, Biswajeet, Hillsboro, OR Oregon 97124 (US); HSU, William, Portland, OR 97229 (US); HARPER, Michael, Hillsboro, OR Oregon 97124 (US); GULER, Leonard, Hillsboro, OR Oregon 97124 (US); GOLONZKA, Oleg, Beaverton, OR Oregon 97007 (US); CRUM, Dax, Beaverton, OR Oregon 97007 (US); LIN, Chung-Hsun, Portland, OR Oregon 97229 (US); GHANI, Tahir, Portland, OR Oregon 97229 (US)
(74) Representative: 2SPL Patentanwälte PartG mbB

(57) **Abstract**

Gate-all-around integrated circuit structures having low aspect ratio isolation structures and subfins, and method of fabricating gate-all-around integrated circuit structures having low aspect ratio isolation structures and subfins, are described. An integrated circuit structure includes a first vertical arrangement of horizontal nanowires above a first subfin (206). A second vertical arrangement of horizontal nanowires is above a second subfin laterally adjacent the first subfin. An isolation structure (210) is laterally between the first subfin and the second subfin, the isolation structure having a maximum height (220) and a maximum width (222) with a maximum height to maximum width ratio of less than 3:1.

## Description

### TECHNICAL FIELD

Embodiments of the disclosure are in the field of integrated circuit structures and processing and, in particular, gate-all-around integrated circuit structures having low aspect ratio isolation structures and subfins.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and because they enable a less complicated tri-gate fabrication process. In another aspect, maintaining mobility improvement and short channel control as microelectronic device dimensions scale below the 10 nanometer (nm) node provides a challenge in device fabrication. Nanowires used to fabricate devices provide improved short channel control.

Scaling multi-gate and nanowire transistors has not been without consequence, however. As the dimensions of these fundamental building blocks of microelectronic circuitry are reduced and as the sheer number of fundamental building blocks fabricated in a given region is increased, the constraints on the lithographic processes used to pattern these building blocks have become overwhelming. In particular, there may be a trade-off between the smallest dimension of a feature patterned in a semiconductor stack (the critical dimension) and the spacing between such features.

### BRIEF DESCRIPTION OF THE DRAWINGS

Figure 1 illustrates a cross-sectional view of a finFET structure having high aspect ratio isolation structures and subfins.
Figure 2 illustrates a cross-sectional view of a nanowire or nanoribbon precursor structure having low aspect ratio isolation structures and subfins, in accordance with an embodiment of the present disclosure.
Figures 3A and 3B illustrate a gate cut cross-sectional view and a fin cut cross-sectional view, respectively, of a gate-all-around integrated circuit structure having a low aspect ratio isolation structure and a low aspect ratio subfin, in accordance with an embodiment of the present disclosure.
Figures 4A-4J illustrates cross-sectional views of various operations in a method of fabricating a gate-all-around integrated circuit structure, in accordance with an embodiment of the present disclosure.
Figure 5 illustrates a cross-sectional view of a non-planar integrated circuit structure as taken along a gate line, in accordance with an embodiment of the present disclosure.
Figure 6 illustrates cross-sectional views representing various operations in a method of fabricating a self-aligned gate endcap (SAGE) structure with gate-all-around devices, in accordance with an embodiment of the present disclosure.
Figure 7A illustrates a three-dimensional cross-sectional view of a nanowire-based integrated circuit structure, in accordance with an embodiment of the present disclosure.
Figure 7B illustrates a cross-sectional source or drain view of the nanowire-based integrated circuit structure of Figure 7A, as taken along the a-a' axis, in accordance with an embodiment of the present disclosure.
Figure 7C illustrates a cross-sectional channel view of the nanowire-based integrated circuit structure of Figure 7A, as taken along the b-b' axis, in accordance with an embodiment of the present disclosure.
Figure 8 illustrates a computing device in accordance with one implementation of an embodiment of the disclosure.
Figure 9 illustrates an interposer that includes one or more embodiments of the disclosure.

### DESCRIPTION OF THE EMBODIMENTS

Gate-all-around integrated circuit structures having low aspect ratio isolation structures and subfins, and method of fabricating gate-all-around integrated circuit structures having low aspect ratio isolation structures and subfins, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments described herein are directed to fin engineering for the integrated flow of nanowire/nanoribbon (NW/NR) transistors, and the resulting devices.

To provide context, epitaxial source or drain structures (EPI S/D) for nanowire transistors are isolated from an underlying substrate by design. Therefore, NMOS and PMOS can be isolated from one another merely by the separation of N-EPI and P-EPI, and a tall fin for isolation is not necessarily needed. This is different from planar FETs and FinFETs, where a shallow trench isolation (STI) with a depth of about 100nm is needed for N/P isolation. Additionally, for FinFETs, a few nanometers loss of fin top during processing (e.g., polish, plasma sputtering, etch) has little impact to performance. However, for nanowire with gate-all-around geometry, the integrity of each nanowire is important in order to provide consistent performance. Having extra fin top protection can be desirable.

In accordance with one or more embodiments of the present disclosure, structures having a relatively shallow fin height for nanowire (or nanoribbon) devices are described. Benefits may include fin stability and/or more facile fin patterning processing with shorter fin height needing cutting in terms of lithography and etch margin at tight fin pitch. On or more embodiments include an added dielectric layer at the nanowire precursor fin top for protection.

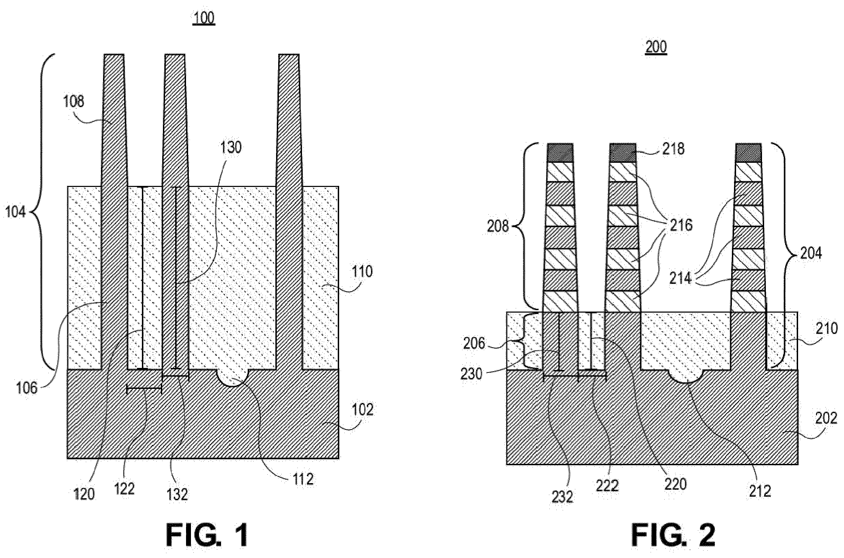

For comparative purposes, Figure 1 illustrates a cross-sectional view of a finFET structure 100 having high aspect ratio isolation structures and subfins.

Referring to Figure 1, finFET structure 100 includes a plurality of fins 104 above and/or protruding from a substrate 102, such as a silicon substrate. Each fin 104 includes a subfin portion 106 and a protruding or active fin portion 108. An isolation structure 110 is between and adjacent to subfin portions 106 of the plurality of fins 104. It is to be appreciated that the plurality of fins 104 can include locations where individual fins have been removed, for example at location 112.

Referring again to Figure 1, the portion of isolation structure 110 between immediately adjacent fins without removed fin locations there between has a maximum height 120 and a maximum width 122, with a substantial maximum height 120 to maximum width 122 ratio, e.g., a maximum height 120 to maximum width 122 ratio of greater than 3:1. The subfin 106 of each of the plurality of fins 104 has a maximum height 130 and a maximum width 132, with a substantial maximum height 130 to maximum width 132 ratio, e.g., a maximum height 130 to maximum width 132 ratio of greater than 3:1.

By contrast to Figure 1, Figure 2 illustrates a cross-sectional view of a nanowire or nanoribbon precursor structure 200 having low aspect ratio isolation structures and subfins, in accordance with an embodiment of the present disclosure.

Referring to Figure 2, nanowire or nanoribbon precursor structure 200 includes a plurality of fins 204 above and/or protruding from a substrate 202, such as a silicon substrate. Each fin 204 includes a subfin portion 206 and a protruding fin portion 208. An isolation structure 210 is between and adjacent to subfin portions 206 of the plurality of fins 204. It is to be appreciated that the plurality of fins 204 can include locations where individual fins have been removed, for example at location 212.

Referring again to Figure 2, each of the protruding fin portions 208 includes a plurality of nanowires or nanoribbons 214 (e.g., silicon nanowires or nanoribbons). Unless stated specifically to the alternative, the terms nanowires and nanoribbons can be used interchangeably throughout this disclosure. Each of the protruding fin portions 208 also includes a sacrificial release layers 216, such as silicon germanium sacrificial release layers. In an embodiment, each of the protruding fin portions 208 also includes a capping dielectric layer 218, which can be included for fin protection, and may ultimately be retained or removed.

Referring again to Figure 2, in an embodiment, the portion of isolation structure 210 between immediately adjacent fins without removed fin locations there between has a maximum height 220 and a maximum width 222, with a relatively low aspect ratio maximum height 220 to maximum width 222 ratio, e.g., a maximum height 220 to maximum width 222 ratio of less than 3:1. In an embodiment, the subfin 206 of each of the plurality of fins 204 has a maximum height 230 and a maximum width 232, with a relatively low aspect ratio maximum height 230 to maximum width 232 ratio, e.g., a maximum height 230 to maximum width 232 ratio of less than 3:1.

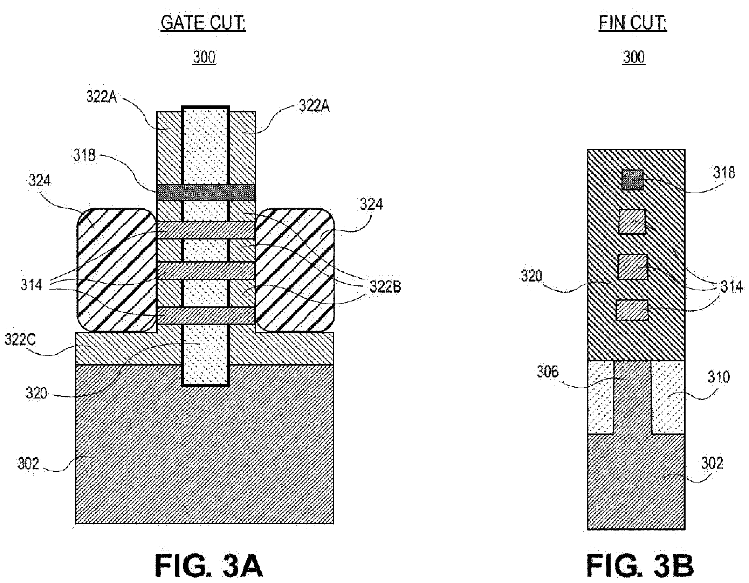

The structure of Figure 2 can be subjected to further processing, such as nanowire release (sacrificial layer removal), gate formation, spacer formation, and epitaxial source or drain formation. As an example, Figures 3A and 3B illustrate a gate cut cross-sectional view and a fin cut cross-sectional view, respectively, of a gate-all-around integrated circuit structure 300 having a low aspect ratio isolation structure and a low aspect ratio subfin, in accordance with an embodiment of the present disclosure.

Referring to Figures 3A and 3B, gate-all-around integrated circuit structure 300 includes a plurality of nanowires 314 above a substrate 302. The nanowires 314 are above a subfin 306 above or protruding from the substrate 302. An isolation structure 310 is either side of the subfin 306. In one embodiment, as is depicted, a dielectric capping layer 318 is above the plurality of nanowires 314. A gate stack 320 (such as a gate electrode and gate dielectric stack) is over the plurality of nanowires 314, around individual nanowires 314, and over the subfin 306. If included, the gate stack 320 can also be over and around the dielectric capping layer 318.

Referring again to Figures 3A and 3B, epitaxial source or drain structures 324 are included at first and second ends of the plurality of nanowires 314. External gate spacers 322A and internal gate spacers 322B are included between the gate stack 320 and the epitaxial source or drain structures 324. Spacer extensions 322C can be included between the epitaxial source or drain structures 324 and the substrate 302. The spacer extensions 322C can be continuous with or discrete from the internal gate spacers 322B. Also, the internal gate spacers 322B can be continuous with or discrete from the external gate spacers 322A.

With reference collectively to Figures 2, 3A and 3B, in accordance with an embodiment of the present disclosure, an integrated circuit structure includes a first vertical arrangement of horizontal nanowires (first 214/314) above a first subfin (first 206/306). A second vertical arrangement of horizontal nanowires (second 214/314) is above a second subfin (second 206/306) laterally adjacent the first subfin (first 206/306). An isolation structure 210/310 is laterally between the first subfin (first 206/306) and the second subfin (second 206/306).

In an embodiment, the isolation structure 210/310 has a maximum height 220 and a maximum width 222 with a maximum height 220 to maximum width 222 ratio of less than 3:1. In one such embodiment, the isolation structure 210/310 has a maximum height 220 and a maximum width 222 with a maximum height 220 to maximum width 222 ratio of less than 2:1. In a specific such embodiment, the isolation structure 210/310 has a maximum height 220 and a maximum width 222 with a maximum height 220 to maximum width 222 ratio of less than 1:1.

In an embodiment, each of the first and second subfins 206/306 has a maximum height 230 and a maximum width 232 with a maximum height 230 to maximum width 232 ratio of less than 3:1. In one such embodiment, each of the first and second subfins 206/306 has a maximum height 230 and a maximum width 232 with a maximum height 230 to maximum width 232 ratio of less than 2:1. In a particular such embodiment, each of the first and second subfins 206/306 has a maximum height 230 and a maximum width 232 with a maximum height 230 to maximum width 232 ratio of less than 1:1.

In an embodiment, a first gate stack (first 320) is over the first vertical arrangement of horizontal nanowires (first 214/314). A second gate stack (second 320) is over the second vertical arrangement of horizontal nanowires (second 214/314). In one such embodiment, each gate stack 320 includes a metal gate electrode and high-k gate dielectric layer. In an embodiment, the first and second subfins 206/306 include or are a portion of a bulk silicon substrate.

In an embodiment, a first pair of epitaxial source or drain structures (first 324) is at first and second ends of the first vertical arrangement of horizontal nanowires (first 214/314) and at first and second sides of the first gate stack (first 320). A second pair of epitaxial source or drain structures (second 324) is at first and second ends of the second vertical arrangement of horizontal nanowires (second 214/314) and at first and second sides of the second gate stack (second 320). In one such embodiment, the first and second pairs of epitaxial source or drain structures 324 are first and second pairs of non-discrete epitaxial source or drain structures, as is depicted and as described in greater detail below. In another such embodiment, the first and second pairs of epitaxial source or drain structures 324 are first and second pairs of discrete epitaxial source or drain structures, not depicted in Figure 3A but as described in greater detail below.

It is to be appreciated, in a particular embodiment, channel layers may be silicon, and intervening layers may be silicon germanium. As used throughout, a silicon layer may be used to describe a silicon material composed of a very substantial amount of, if not all, silicon. However, it is to be appreciated that, practically, 100% pure Si may be difficult to form and, hence, could include a tiny percentage of carbon, germanium or tin. Such impurities may be included as an unavoidable impurity or component during deposition of Si or may "contaminate" the Si upon diffusion during post deposition processing. As such, embodiments described herein directed to a silicon layer may include a silicon layer that contains a relatively small amount, e.g., "impurity" level, non-Si atoms or species, such as Ge, C or Sn. It is to be appreciated that a silicon layer as described herein may be undoped or may be doped with dopant atoms such as boron, phosphorous or arsenic.

As used throughout, a silicon germanium layer may be used to describe a silicon germanium material composed of substantial portions of both silicon and germanium, such as at least 5% of both. In some embodiments, the amount of germanium is greater than the amount of silicon. In particular embodiments, a silicon germanium layer includes approximately 60% germanium and approximately 40% silicon (Si₄₀Ge₆₀). In other embodiments, the amount of silicon is greater than the amount of germanium. In particular embodiments, a silicon germanium layer includes approximately 30% germanium and approximately 70% silicon (Si₇₀Ge₃₀). It is to be appreciated that, practically, 100% pure silicon germanium (referred to generally as SiGe) may be difficult to form and, hence, could include a tiny percentage of carbon or tin. Such impurities may be included as an unavoidable impurity or component during deposition of SiGe or may "contaminate" the SiGe upon diffusion during post deposition processing. As such, embodiments described herein directed to a silicon germanium layer may include a silicon germanium layer that contains a relatively small amount, e.g., "impurity" level, non-Ge and non-Si atoms or species, such as carbon or tin. It is to be appreciated that a silicon germanium layer as described herein may be undoped or may be doped with dopant atoms such as boron, phosphorous or arsenic.

Described below are various processing schemes and devices that may involve a gate-all-around integrated circuit structure having low aspect ratio isolation structures and a low aspect ratio subfin. It is to be appreciated that the exemplary embodiments need not necessarily require all features described, or may include more features than are described.

Nanowire release processing may be performed through a replacement gate trench. Additional examples of such release processes are described below. Additionally, in yet another aspect, backend (BE) interconnect scaling can result in lower performance and higher manufacturing cost due to patterning complexity. Embodiments described herein may be implemented to enable front-side and back-side interconnect integration for nanowire transistors. Embodiments described herein may provide an approach to achieve a relatively wider interconnect pitch. The result may be improved product performance and lower patterning costs. Embodiments may be implemented to enable robust functionality of scaled nanowire or nanoribbon transistors with low power and high performance.

One or more embodiments described herein are directed dual epitaxial (EPI) connections for nanowire or nanoribbon transistors using partial source or drain (SD) and asymmetric trench contact (TCN) depth. In an embodiment, an integrated circuit structure is fabricated by forming source-drain openings of nanowire/nanoribbon transistors which are partially filled with SD epitaxy. A remainder of the opening is filled with a conductive material. Deep trench formation on one of the source or drain side enables direct contact to a back-side interconnect level.

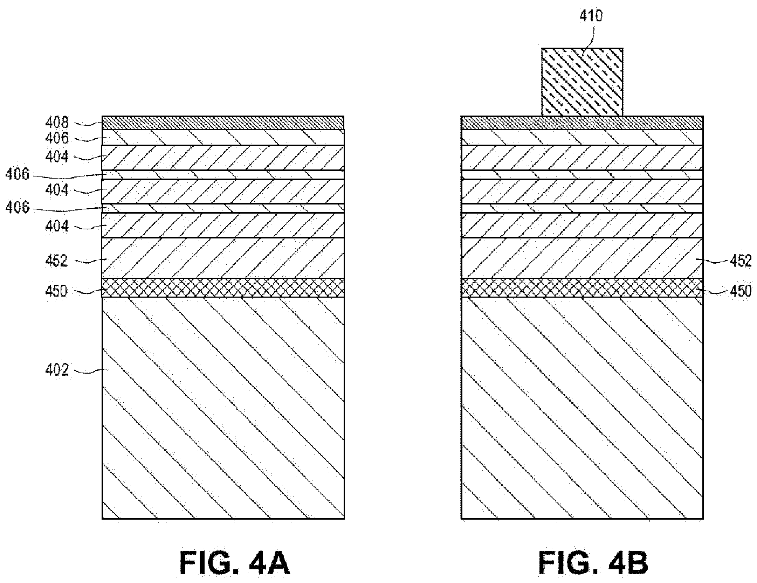

As an exemplary process flow for fabricating a gate-all-around device of a gate-all-around integrated circuit structure having a device with channel-to-substrate electrical contact, Figures 4A-4J illustrates cross-sectional views of various operations in a method of fabricating a gate-all-around integrated circuit structure, in accordance with an embodiment of the present disclosure.

Referring to Figure 4A, a method of fabricating an integrated circuit structure includes forming a starting stack which includes alternating sacrificial layers 404 and nanowires 406 above a fin 402, such as a silicon fin. The nanowires 406 may be referred to as a vertical arrangement of nanowires. A protective cap 408 may be formed above the alternating sacrificial layers 404 and nanowires 406, as is depicted. A relaxed buffer layer 452 and a defect modification layer 450 may be formed beneath the alternating sacrificial layers 404 and nanowires 406, as is also depicted.

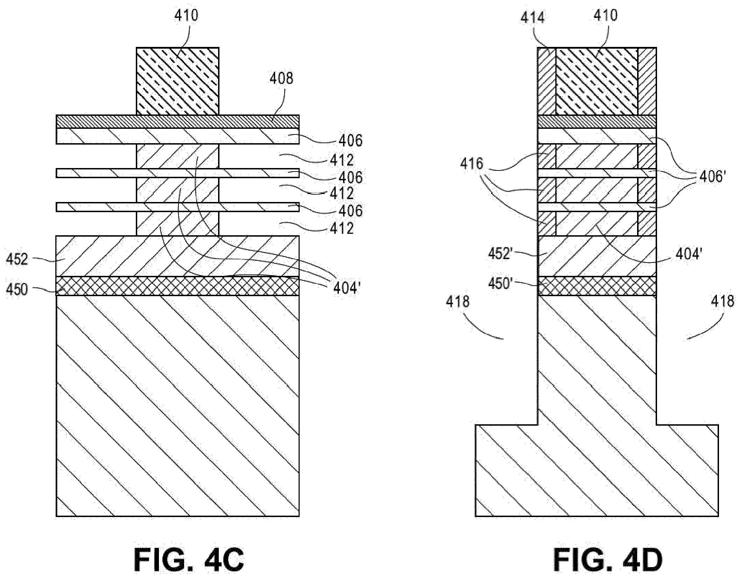

Referring to Figure 4B, a gate stack 410 is formed over the vertical arrangement of horizontal nanowires 406. Portions of the vertical arrangement of horizontal nanowires 406 are then released by removing portions of the sacrificial layers 404 to provide recessed sacrificial layers 404' and cavities 412, as is depicted in Figure 4C.

It is to be appreciated that the structure of Figure 4C may be fabricated to completion without first performing the deep etch and asymmetric contact processing described below. In either case (e.g., with or without asymmetric contact processing), in an embodiment, a fabrication process involves use of a process scheme that provides a gate-all-around integrated circuit structure having epitaxial nubs, which may be vertically discrete source or drain structures.

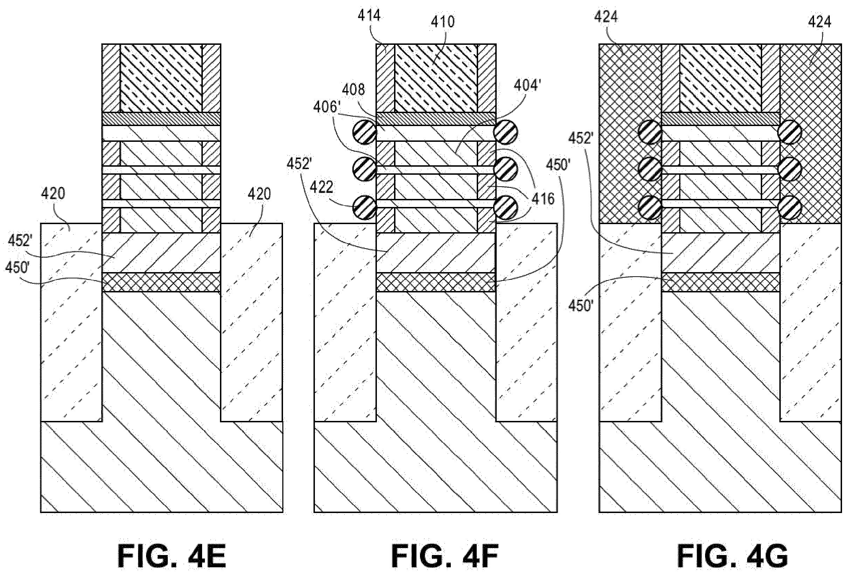

Referring to Figure 4D, upper gate spacers 414 are formed at sidewalls of the gate structure 410. Cavity spacers 416 are formed in the cavities 412 beneath the upper gate spacers 414. A deep trench contact etch is then optionally performed to form trenches 418 and to form recessed nanowires 406'. A patterned relaxed buffer layer 452' and a patterned defect modification layer 450' may also be present, as is depicted. A sacrificial material 420 is then formed in the trenches 418, as is depicted in Figure 4E. In other process schemes, an isolated trench bottom or silicon trench bottom may be used.

Referring to Figure 4F, a first epitaxial source or drain structure (e.g., left-hand features 422) is formed at a first end of the vertical arrangement of horizontal nanowires 406'. A second epitaxial source or drain structure (e.g., right-hand features 422) is formed at a second end of the vertical arrangement of horizontal nanowires 406'. In an embodiment, as depicted, the epitaxial source or drain structures 422 are vertically discrete source or drain structures and may be referred to as epitaxial nubs.

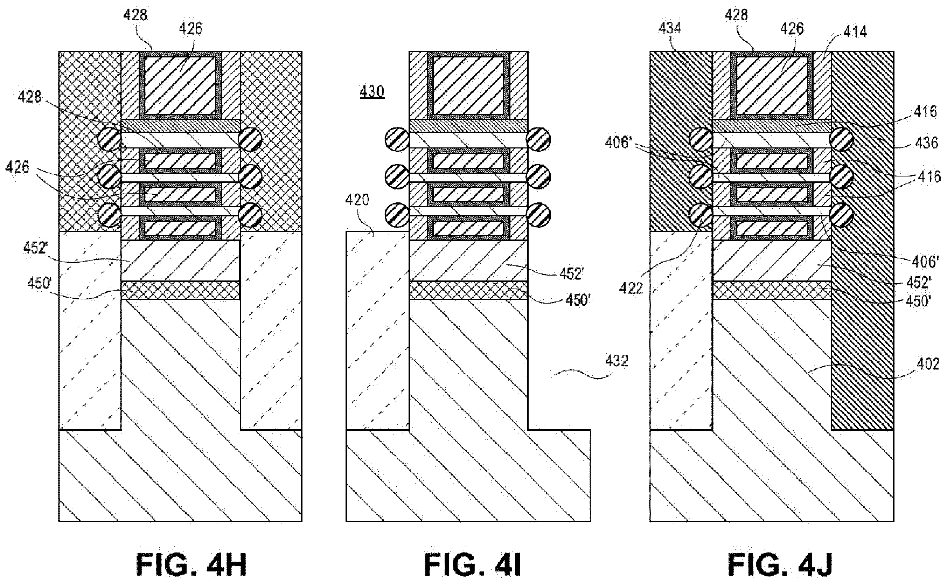

An inter-layer dielectric (ILD) material 424 is then formed at the sides of the gate electrode 410 and adjacent the source or drain structures 422, as is depicted in Figure 4G. Referring to Figure 4H, a replacement gate process is used to form a permanent gate dielectric 428 and a permanent gate electrode 426. The ILD material 424 is then removed, as is depicted in Figure 4I. The sacrificial material 420 is then removed from one of the source drain locations (e.g., right-hand side) to form trench 432, but is not removed from the other of the source drain locations to form trench 430.

Referring to Figure 4J, a first conductive contact structure 434 is formed coupled to the first epitaxial source or drain structure (e.g., left-hand features 422). A second conductive contact structure 436 is formed coupled to the second epitaxial source or drain structure (e.g., right-hand features 422). The second conductive contact structure 436 is formed deeper along the fin 402 than the first conductive contact structure 434. In an embodiment, although not depicted in Figure 4J, the method further includes forming an exposed surface of the second conductive contact structure 436 at a bottom of the fin 402. Conductive contacts may include a contact resistance reducing layer and a primary contact electrode layer, where examples can include Ti, Ni, Co (for the former and W, Ru, Co for the latter.)

In an embodiment, the second conductive contact structure 436 is deeper along the fin 402 than the first conductive contact structure 434, as is depicted. In one such embodiment, the first conductive contact structure 434 is not along the fin 402, as is depicted. In another such embodiment, not depicted, the first conductive contact structure 434 is partially along the fin 402.

In an embodiment, the second conductive contact structure 436 is along an entirety of the fin 402. In an embodiment, although not depicted, in the case that the bottom of the fin 402 is exposed by a back-side substrate removal process, the second conductive contact structure 436 has an exposed surface at a bottom of the fin 402.

In an embodiment, structures fabricated using the processing scheme or portions of the processing scheme described in association with Figures 4A-4J can be fabricated to include a low aspect ratio isolation structure and/or a low aspect ratio subfin, such as described above in association with Figures 2, 3A and 3B. In one such embodiment, such an isolation structure has a maximum height and a maximum width with a maximum height to maximum width ratio of less than 3:1. In one such embodiment, such a subfin has a maximum height and a maximum width with a maximum height to maximum width ratio of less than 3:1.

In another aspect, in order to enable access to both conductive contact structures of a pair of asymmetric source and drain contact structures, integrated circuit structures described herein may be fabricated using a back-side reveal of front-side structures fabrication approach. In some exemplary embodiments, reveal of the back-side of a transistor or other device structure entails wafer-level back-side processing. In contrast to a conventional TSV-type technology, a reveal of the back-side of a transistor as described herein may be performed at the density of the device cells, and even within sub-regions of a device. Furthermore, such a reveal of the back-side of a transistor may be performed to remove substantially all of a donor substrate upon which a device layer was disposed during front-side device processing. As such, a microns-deep TSV becomes unnecessary with the thickness of semiconductor in the device cells following a reveal of the back-side of a transistor potentially being only tens or hundreds of nanometers.

Reveal techniques described herein may enable a paradigm shift from "bottom-up" device fabrication to "center-out" fabrication, where the "center" is any layer that is employed in front-side fabrication, revealed from the back-side, and again employed in back-side fabrication. Processing of both a front-side and revealed back-side of a device structure may address many of the challenges associated with fabricating 3D ICs when primarily relying on front-side processing.

A reveal of the back-side of a transistor approach may be employed for example to remove at least a portion of a carrier layer and intervening layer of a donor-host substrate assembly. The process flow begins with an input of a donor-host substrate assembly. A thickness of a carrier layer in the donor-host substrate is polished (e.g., CMP) and/or etched with a wet or dry (e.g., plasma) etch process. Any grind, polish, and/or wet/dry etch process known to be suitable for the composition of the carrier layer may be employed. For example, where the carrier layer is a group IV semiconductor (e.g., silicon) a CMP slurry known to be suitable for thinning the semiconductor may be employed. Likewise, any wet etchant or plasma etch process known to be suitable for thinning the group IV semiconductor may also be employed.

In some embodiments, the above is preceded by cleaving the carrier layer along a fracture plane substantially parallel to the intervening layer. The cleaving or fracture process may be utilized to remove a substantial portion of the carrier layer as a bulk mass, reducing the polish or etch time needed to remove the carrier layer. For example, where a carrier layer is 400-900 µm in thickness, 100-700 µm may be cleaved off by practicing any blanket implant known to promote a wafer-level fracture. In some exemplary embodiments, a light element (e.g., H, He, or Li) is implanted to a uniform target depth within the carrier layer where the fracture plane is desired. Following such a cleaving process, the thickness of the carrier layer remaining in the donor-host substrate assembly may then be polished or etched to complete removal. Alternatively, where the carrier layer is not fractured, the grind, polish and/or etch operation may be employed to remove a greater thickness of the carrier layer.

Next, exposure of an intervening layer is detected. Detection is used to identify a point when the back-side surface of the donor substrate has advanced to nearly the device layer. Any endpoint detection technique known to be suitable for detecting a transition between the materials employed for the carrier layer and the intervening layer may be practiced. In some embodiments, one or more endpoint criteria are based on detecting a change in optical absorbance or emission of the back-side surface of the donor substrate during the polishing or etching performed. In some other embodiments, the endpoint criteria are associated with a change in optical absorbance or emission of byproducts during the polishing or etching of the donor substrate back-side surface. For example, absorbance or emission wavelengths associated with the carrier layer etch byproducts may change as a function of the different compositions of the carrier layer and intervening layer. In other embodiments, the endpoint criteria are associated with a change in mass of species in byproducts of polishing or etching the back-side surface of the donor substrate. For example, the byproducts of processing may be sampled through a quadrupole mass analyzer and a change in the species mass may be correlated to the different compositions of the carrier layer and intervening layer. In another exemplary embodiment, the endpoint criteria is associated with a change in friction between a back-side surface of the donor substrate and a polishing surface in contact with the back-side surface of the donor substrate.

Detection of the intervening layer may be enhanced where the removal process is selective to the carrier layer relative to the intervening layer as non-uniformity in the carrier removal process may be mitigated by an etch rate delta between the carrier layer and intervening layer. Detection may even be skipped if the grind, polish and/or etch operation removes the intervening layer at a rate sufficiently below the rate at which the carrier layer is removed. If an endpoint criteria is not employed, a grind, polish and/or etch operation of a predetermined fixed duration may stop on the intervening layer material if the thickness of the intervening layer is sufficient for the selectivity of the etch. In some examples, the carrier etch rate: intervening layer etch rate is 3:1-10:1, or more.

Upon exposing the intervening layer, at least a portion of the intervening layer may be removed. For example, one or more component layers of the intervening layer may be removed. A thickness of the intervening layer may be removed uniformly by a polish, for example. Alternatively, a thickness of the intervening layer may be removed with a masked or blanket etch process. The process may employ the same polish or etch process as that employed to thin the carrier, or may be a distinct process with distinct process parameters. For example, where the intervening layer provides an etch stop for the carrier removal process, the latter operation may employ a different polish or etch process that favors removal of the intervening layer over removal of the device layer. Where less than a few hundred nanometers of intervening layer thickness is to be removed, the removal process may be relatively slow, optimized for across-wafer uniformity, and more precisely controlled than that employed for removal of the carrier layer. A CMP process employed may, for example employ a slurry that offers very high selectively (e.g., 100:1-300:1, or more) between semiconductor (e.g., silicon) and dielectric material (e.g., SiO) surrounding the device layer and embedded within the intervening layer, for example, as electrical isolation between adjacent device regions.

For embodiments where the device layer is revealed through complete removal of the intervening layer, back-side processing may commence on an exposed back-side of the device layer or specific device regions there in. In some embodiments, the back-side device layer processing includes a further polish or wet/dry etch through a thickness of the device layer disposed between the intervening layer and a device region previously fabricated in the device layer, such as a source or drain region.

In some embodiments where the carrier layer, intervening layer, or device layer back-side is recessed with a wet and/or plasma etch, such an etch may be a patterned etch or a materially selective etch that imparts significant non-planarity or topography into the device layer back-side surface. As described further below, the patterning may be within a device cell (i.e., "intra-cell" patterning) or may be across device cells (i.e., "inter-cell" patterning). In some patterned etch embodiments, at least a partial thickness of the intervening layer is employed as a hard mask for back-side device layer patterning. Hence, a masked etch process may preface a correspondingly masked device layer etch.

The above described processing scheme may result in a donor-host substrate assembly that includes IC devices that have a back-side of an intervening layer, a back-side of the device layer, and/or back-side of one or more semiconductor regions within the device layer, and/or front-side metallization revealed. Additional back-side processing of any of these revealed regions may then be performed during downstream processing.

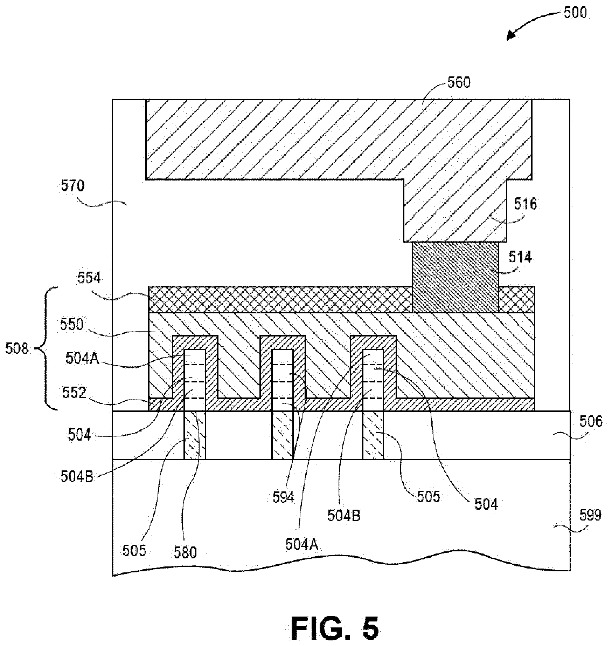

It is to be appreciated that the structures resulting from the above exemplary processing schemes may be used in a same or similar form for subsequent processing operations to complete device fabrication, such as PMOS and/or NMOS device fabrication. As an example of a completed device, Figure 5 illustrate a cross-sectional view of a non-planar integrated circuit structure as taken along a gate line, in accordance with an embodiment of the present disclosure.

Referring to Figure 5, a semiconductor structure or device 500 includes a non-planar active region (e.g., a fin structure including protruding fin portion 504 and sub-fin region 505) within a trench isolation region 506 above a substrate 599. In an embodiment, instead of a solid fin, the non-planar active region is separated into nanowires (such as nanowires 504A and 504B) above sub-fin region 505, as is represented by the dashed lines. That is, material at locations 594, such as a sacrificial release material is removed. For ease of description for non-planar integrated circuit structure 500, a non-planar active region 504 is referenced below as a protruding fin portion.

In an embodiment, each subfin region 505 is a low aspect ratio subfin, such as described above in association with Figures 2, 3A and 3B. In one such embodiment, such a subfin has a maximum height and a maximum width with a maximum height to maximum width ratio of less than 3:1. In an embodiment, each portion of trench isolation region 506 between adjacent subfin regions 505 is a low aspect ratio isolation structure, such as described above in association with Figures 2, 3A and 3B. In one such embodiment, such an isolation structure has a maximum height and a maximum width with a maximum height to maximum width ratio of less than 3:1.

A gate line 508 is disposed over the protruding portions 504 of the non-planar active region (including, if applicable, surrounding nanowires 504A and 504B), as well as over a portion of the trench isolation region 506. As shown, gate line 508 includes a gate electrode 550 and a gate dielectric layer 552. In one embodiment, gate line 508 may also include a dielectric cap layer 554. A gate contact 514, and overlying gate contact via 516 are also seen from this perspective, along with an overlying metal interconnect 560, all of which are disposed in inter-layer dielectric stacks or layers 570. Also seen from the perspective of Figure 5, the gate contact 514 is, in one embodiment, disposed over trench isolation region 506, but not over the non-planar active regions. In another embodiment, the gate contact 514 is over the non-planar active regions.

In an embodiment, the semiconductor structure or device 500 is a non-planar device such as, but not limited to, a fin-FET device, a tri-gate device, a nanoribbon device, or a nanowire device. In such an embodiment, a corresponding semiconducting channel region is composed of or is formed in a three-dimensional body. In one such embodiment, the gate electrode stacks of gate lines 508 surround at least a top surface and a pair of sidewalls of the three-dimensional body.

As is also depicted in Figure 5, in an embodiment, an interface 580 exists between a protruding fin portion 504 and sub-fin region 505. The interface 580 can be a transition region between a doped sub-fin region 505 and a lightly or undoped upper fin portion 504. In one such embodiment, each fin is approximately 10 nanometers wide or less, and sub-fin dopants are optionally supplied from an adjacent solid state doping layer at the sub-fin location. In a particular such embodiment, each fin is less than 10 nanometers wide.

Although not depicted in Figure 5, it is to be appreciated that source or drain regions of or adjacent to the protruding fin portions 504 are on either side of the gate line 508, i.e., into and out of the page. In one embodiment, the material of the protruding fin portions 504 in the source or drain locations is removed and replaced with another semiconductor material, e.g., by epitaxial deposition to form epitaxial source or drain structures. The source or drain regions may extend below the height of dielectric layer of trench isolation region 506, i.e., into the sub-fin region 505. In accordance with an embodiment of the present disclosure, the more heavily doped sub-fin regions, i.e., the doped portions of the fins below interface 580, inhibits source to drain leakage through this portion of the bulk semiconductor fins. In an embodiment, the source and drain regions have associated asymmetric source and drain contact structures, as described above in association with Figure 4J.

With reference again to Figure 5, in an embodiment, fins 504/505 (and, possibly nanowires 504A and 504B) are composed of a crystalline silicon germanium layer which may be doped with a charge carrier, such as but not limited to phosphorus, arsenic, boron, gallium or a combination thereof.

In an embodiment, trench isolation region 506, and trench isolation regions (trench isolations structures or trench isolation layers) described throughout, may be composed of a material suitable to ultimately electrically isolate, or contribute to the isolation of, portions of a permanent gate structure from an underlying bulk substrate or isolate active regions formed within an underlying bulk substrate, such as isolating fin active regions. For example, in one embodiment, trench isolation region 506 is composed of a dielectric material such as, but not limited to, silicon dioxide, silicon oxy-nitride, silicon nitride, or carbon-doped silicon nitride.

Gate line 508 may be composed of a gate electrode stack which includes a gate dielectric layer 552 and a gate electrode layer 550. In an embodiment, the gate electrode of the gate electrode stack is composed of a metal gate and the gate dielectric layer 552 is composed of a high-k material. For example, in one embodiment, the gate dielectric layer 552 is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer 552 may include a layer of native oxide formed from the top few layers of the substrate fin 504. In an embodiment, the gate dielectric layer 552 is composed of a top high-k portion and a lower portion composed of an oxide of a semiconductor material. In one embodiment, the gate dielectric layer 552 is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, the gate electrode layer 550 is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode layer 550 is composed of a non-workfunction-setting fill material formed above a metal workfunction-setting layer. The gate electrode layer 550 may consist of a P-type workfunction metal or an N-type workfunction metal, depending on whether the transistor is to be a PMOS or an NMOS transistor. In some implementations, the gate electrode layer 550 may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U'-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode layer 550 may consist of one or more U-shaped metal layers formed atop one or more planar, non-U-shaped layers.

Spacers associated with the gate electrode stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

Gate contact 514 and overlying gate contact via 516 may be composed of a conductive material. In an embodiment, one or more of the contacts or vias are composed of a metal species. The metal species may be a pure metal, such as tungsten, nickel, or cobalt, or may be an alloy such as a metal-metal alloy or a metal-semiconductor alloy (e.g., such as a silicide material).

In an embodiment (although not shown), a contact pattern which is essentially perfectly aligned to an existing gate pattern 508 is formed while eliminating the use of a lithographic step with exceedingly tight registration budget. In an embodiment, the contact pattern is a vertically symmetric contact pattern, or an asymmetric contact pattern such as described in association with Figure 4J. In other embodiments, all contacts are front-side connected and are not asymmetric. In one such embodiment, the self-aligned approach enables the use of intrinsically highly selective wet etching (e.g., versus conventionally implemented dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in conventional approaches. In an embodiment, a trench contact grid is not separately patterned, but is rather formed between poly (gate) lines. For example, in one such embodiment, a trench contact grid is formed subsequent to gate grating patterning but prior to gate grating cuts.

In an embodiment, providing structure 500 involves fabrication of the gate stack structure 508 by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

Referring again to Figure 5, the arrangement of semiconductor structure or device 500 places the gate contact over isolation regions. Such an arrangement may be viewed as inefficient use of layout space. In another embodiment, however, a semiconductor device has contact structures that contact portions of a gate electrode formed over an active region, e.g., over a sub-fin region 505, and in a same layer as a trench contact via.

It is to be appreciated that not all aspects of the processes described above need be practiced to fall within the spirit and scope of embodiments of the present disclosure. Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a tri-gate device, an independently accessed double gate device, or a FIN-FET. One or more embodiments may be particularly useful for fabricating semiconductor devices at a sub-10 nanometer (10 nm) technology node.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by conventional techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials, capping layers, or plugs are composed of dielectric materials different from the interlayer dielectric material. In one embodiment, different hardmask, capping or plug materials may be used in different regions so as to provide different growth or etch selectivity to each other and to the underlying dielectric and metal layers. In some embodiments, a hardmask layer, capping or plug layer includes a layer of a nitride of silicon (e.g., silicon nitride) or a layer of an oxide of silicon, or both, or a combination thereof. Other suitable materials may include carbon-based materials. Other hardmask, capping or plug layers known in the arts may be used depending upon the particular implementation. The hardmask, capping or plug layers maybe formed by CVD, PVD, or by other deposition methods.

In an embodiment, as is also used throughout the present description, lithographic operations are performed using 193nm immersion lithography (i193), EUV and/or EBDW lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

In another aspect, one or more embodiments are directed to neighboring semiconductor structures or devices separated by self-aligned gate endcap (SAGE) structures. Particular embodiments may be directed to integration of multiple width (multi-Wsi) nanowires and nanoribbons in a SAGE architecture and separated by a SAGE wall. In an embodiment, nanowires/nanoribbons are integrated with multiple Wsi in a SAGE architecture portion of a front-end process flow. Such a process flow may involve integration of nanowires and nanoribbons of different Wsi to provide robust functionality of next generation transistors with low power and high performance. Associated epitaxial source or drain regions may be embedded (e.g., portions of nanowires removed and then source or drain (S/D) growth is performed).

To provide further context, advantages of a self-aligned gate endcap (SAGE) architecture may include the enabling of higher layout density and, in particular, scaling of diffusion to diffusion spacing. A self-aligned gate endcap (SAGE) processing scheme involves the formation of gate/trench contact endcaps self-aligned to fins without requiring an extra length to account for mask mis-registration. Thus, embodiments may be implemented to enable shrinking of transistor layout area. Embodiments described herein may involve the fabrication of gate endcap isolation structures, which may also be referred to as gate walls, isolation gate walls or self-aligned gate endcap (SAGE) walls.

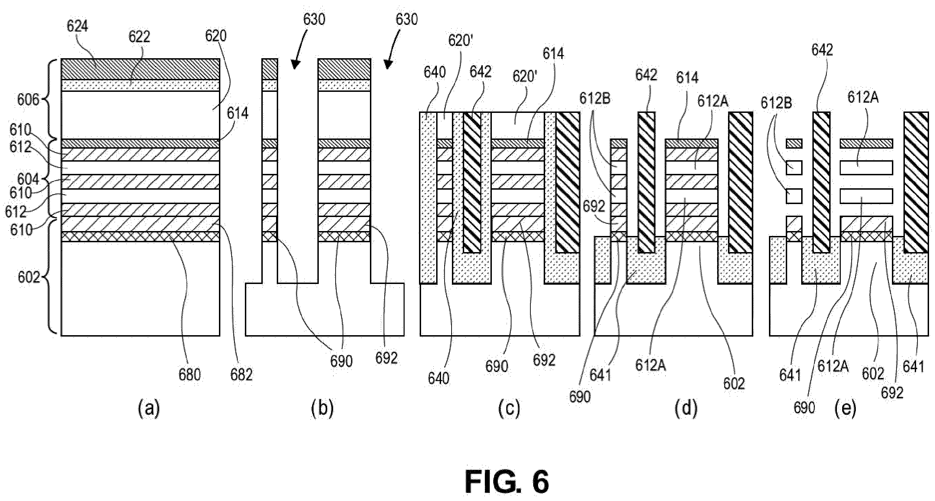

In an exemplary processing scheme for structures having SAGE walls separating neighboring devices, Figure 6 illustrates cross-sectional views representing various operations in a method of fabricating a self-aligned gate endcap (SAGE) structure with gate-all-around devices, in accordance with an embodiment of the present disclosure.

Referring to part (a) of Figure 6, a starting structure includes a nanowire patterning stack 604 above a substrate 602. A lithographic patterning stack 606 is formed above the nanowire patterning stack 604. The nanowire patterning stack 604 includes alternating sacrificial layers 610 and nanowire layers 612, which may be above a relaxed buffer layer 682 and a defect modification layer 680, as is depicted. A protective mask 614 is between the nanowire patterning stack 604 and the lithographic patterning stack 606. In one embodiment, the lithographic patterning stack 606 is trilayer mask composed of a topographic masking portion 620, an anti-reflective coating (ARC) layer 622, and a photoresist layer 624. In a particular such embodiment, the topographic masking portion 620 is a carbon hardmask (CHM) layer and the anti-reflective coating layer 622 is a silicon ARC layer.

Referring to part (b) of Figure 6, the stack of part (a) is lithographically patterned and then etched to provide an etched structure including a patterned substrate 602 and trenches 630.

Referring to part (c) of Figure 6, the structure of part (b) has an isolation layer 640 and a SAGE material 642 formed in trenches 630. The structure is then planarized to leave patterned topographic masking layer 620' as an exposed upper layer.

Referring to part (d) of Figure 6, the isolation layer 640 is recessed below an upper surface of the patterned substrate 602, e.g., to define a protruding fin portion and to provide a trench isolation structure 641 beneath SAGE walls 642.

Referring to part (e) of Figure 6, the sacrificial layers 610 are removed at least in the channel region to release nanowires 612A and 612B. Subsequent to the formation of the structure of part (e) of Figure 6, a gate stacks may be formed around nanowires 612B or 612A, over protruding fins of substrate 602, and between SAGE walls 642. In one embodiment, prior to formation of the gate stacks, the remaining portion of protective mask 614 is removed. In another embodiment, the remaining portion of protective mask 614 is retained as an insulating fin hat as an artifact of the processing scheme.

Referring again to part (e) of Figure 6, it is to be appreciated that a channel view is depicted, with source or drain regions being locating into and out of the page. In an embodiment, the channel region including nanowires 612B has a width less than the channel region including nanowires 612A. Thus, in an embodiment, an integrated circuit structure includes multiple width (multi-Wsi) nanowires. Although structures of 612B and 612A may be differentiated as nanowires and nanoribbons, respectively, both such structures are typically referred to herein as nanowires. It is also to be appreciated that reference to or depiction of a fin/nanowire pair throughout may refer to a structure including a fin and one or more overlying nanowires (e.g., two overlying nanowires are shown in Figure 6). In accordance with an embodiment of the present disclosure, a fabrication process for structures associated with Figure 6 involves use of a process scheme that provides a gate-all-around integrated circuit structure having epitaxial source or drain structures.

In an embodiment, the structure of part (e) Figure 6 can be fabricated to include a low aspect ratio isolation structure and/or a low aspect ratio subfin, such as described above in association with Figures 2, 3A and 3B. In one such embodiment, such an isolation structure has a maximum height and a maximum width with a maximum height to maximum width ratio of less than 3:1. In one such embodiment, such a subfin has a maximum height and a maximum width with a maximum height to maximum width ratio of less than 3:1.

In an embodiment, as described throughout, self-aligned gate endcap (SAGE) isolation structures may be composed of a material or materials suitable to ultimately electrically isolate, or contribute to the isolation of, portions of permanent gate structures from one another. Exemplary materials or material combinations include a single material structure such as silicon dioxide, silicon oxy-nitride, silicon nitride, or carbon-doped silicon nitride. Other exemplary materials or material combinations include a multi-layer stack having lower portion silicon dioxide, silicon oxy-nitride, silicon nitride, or carbon-doped silicon nitride and an upper portion higher dielectric constant material such as hafnium oxide.

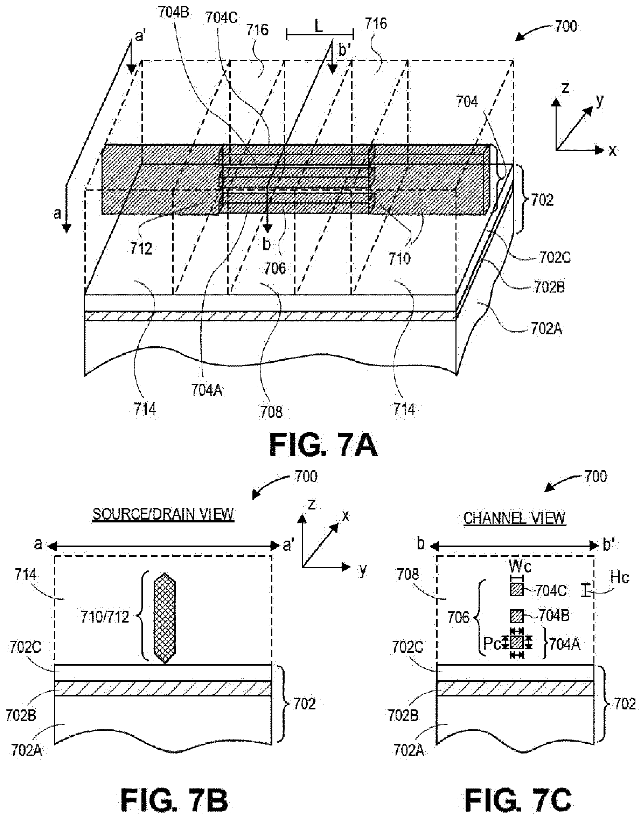

To highlight an exemplary integrated circuit structure having three vertically arranged nanowires, Figure 7A illustrates a three-dimensional cross-sectional view of a nanowire-based integrated circuit structure, in accordance with an embodiment of the present disclosure. Figure 7B illustrates a cross-sectional source or drain view of the nanowire-based integrated circuit structure of Figure 7A, as taken along the a-a' axis. Figure 7C illustrates a cross-sectional channel view of the nanowire-based integrated circuit structure of Figure 7A, as taken along the b-b' axis.

Referring to Figure 7A, an integrated circuit structure 700 includes one or more vertically stacked nanowires (704 set) above a substrate 702. In an embodiment, as depicted, a relaxed buffer layer 702C, a defect modification layer 702B, and a lower substrate portion 702A are included in substrate 702, as is depicted. An optional fin below the bottommost nanowire and formed from the substrate 702 is not depicted for the sake of emphasizing the nanowire portion for illustrative purposes. Embodiments herein are targeted at both single wire devices and multiple wire devices. As an example, a three nanowire-based devices having nanowires 704A, 704B and 704C is shown for illustrative purposes. For convenience of description, nanowire 704A is used as an example where description is focused on one of the nanowires. It is to be appreciated that where attributes of one nanowire are described, embodiments based on a plurality of nanowires may have the same or essentially the same attributes for each of the nanowires.

Each of the nanowires 704 includes a channel region 706 in the nanowire. The channel region 706 has a length (L). Referring to Figure 7C, the channel region also has a perimeter (Pc) orthogonal to the length (L). Referring to both Figures 7A and 7C, a gate electrode stack 708 surrounds the entire perimeter (Pc) of each of the channel regions 706. The gate electrode stack 708 includes a gate electrode along with a gate dielectric layer between the channel region 706 and the gate electrode (not shown). In an embodiment, the channel region is discrete in that it is completely surrounded by the gate electrode stack 708 without any intervening material such as underlying substrate material or overlying channel fabrication materials. Accordingly, in embodiments having a plurality of nanowires 704, the channel regions 706 of the nanowires are also discrete relative to one another.

Referring to both Figures 7A and 7B, integrated circuit structure 700 includes a pair of non-discrete source or drain regions 710/712. The pair of non-discrete source or drain regions 710/712 is on either side of the channel regions 706 of the plurality of vertically stacked nanowires 704. Furthermore, the pair of non-discrete source or drain regions 710/712 is adjoining for the channel regions 706 of the plurality of vertically stacked nanowires 704. In one such embodiment, not depicted, the pair of non-discrete source or drain regions 710/712 is directly vertically adjoining for the channel regions 706 in that epitaxial growth is on and between nanowire portions extending beyond the channel regions 706, where nanowire ends are shown within the source or drain structures. In another embodiment, as depicted in Figure 7A, the pair of non-discrete source or drain regions 710/712 is indirectly vertically adjoining for the channel regions 706 in that they are formed at the ends of the nanowires and not between the nanowires.

In an embodiment, as depicted, the source or drain regions 710/712 are non-discrete in that there are not individual and discrete source or drain regions for each channel region 706 of a nanowire 704. Accordingly, in embodiments having a plurality of nanowires 704, the source or drain regions 710/712 of the nanowires are global or unified source or drain regions as opposed to discrete for each nanowire. That is, the non-discrete source or drain regions 710/712 are global in the sense that a single unified feature is used as a source or drain region for a plurality (in this case, 3) of nanowires 704 and, more particularly, for more than one discrete channel region 706. In one embodiment, from a cross-sectional perspective orthogonal to the length of the discrete channel regions 706, each of the pair of non-discrete source or drain regions 710/712 is approximately rectangular in shape with a bottom tapered portion and a top vertex portion, as depicted in Figure 7B. In other embodiments, however, the source or drain regions 710/712 of the nanowires are relatively larger yet discrete non-vertically merged epitaxial structures such as nubs described in association with Figures 4A-4J.

In accordance with an embodiment of the present disclosure, and as depicted in Figures 7A and 7B, integrated circuit structure 700 further includes a pair of contacts 714, each contact 714 on one of the pair of non-discrete source or drain regions 710/712. In one such embodiment, in a vertical sense, each contact 714 completely surrounds the respective non-discrete source or drain region 710/712. In another aspect, the entire perimeter of the non-discrete source or drain regions 710/712 may not be accessible for contact with contacts 714, and the contact 714 thus only partially surrounds the non-discrete source or drain regions 710/712, as depicted in Figure 7B. In a contrasting embodiment, not depicted, the entire perimeter of the non-discrete source or drain regions 710/712, as taken along the a-a' axis, is surrounded by the contacts 714.

Referring again to Figure 7A, in an embodiment, integrated circuit structure 700 further includes a pair of spacers 716. As is depicted, outer portions of the pair of spacers 716 may overlap portions of the non-discrete source or drain regions 710/712, providing for "embedded" portions of the non-discrete source or drain regions 710/712 beneath the pair of spacers 716. As is also depicted, the embedded portions of the non-discrete source or drain regions 710/712 may not extend beneath the entirety of the pair of spacers 716.

Substrate 702 may be composed of a material suitable for integrated circuit structure fabrication. In one embodiment, substrate 702 includes a lower bulk substrate composed of a single crystal of a material which may include, but is not limited to, silicon, germanium, silicon-germanium, germanium-tin, silicon-germanium-tin, or a group III-V compound semiconductor material. An upper insulator layer composed of a material which may include, but is not limited to, silicon dioxide, silicon nitride or silicon oxy-nitride is on the lower bulk substrate. Thus, the structure 700 may be fabricated from a starting semiconductor-on-insulator substrate. Alternatively, the structure 700 is formed directly from a bulk substrate and local oxidation is used to form electrically insulative portions in place of the above described upper insulator layer. In another alternative embodiment, the structure 700 is formed directly from a bulk substrate and doping is used to form electrically isolated active regions, such as nanowires, thereon. In one such embodiment, the first nanowire (i.e., proximate the substrate) is in the form of an omega-FET type structure.

In an embodiment, the nanowires 704 may be sized as wires or ribbons, as described below, and may have squared-off or rounder corners. In an embodiment, the nanowires 704 are composed of a material such as, but not limited to, silicon, germanium, or a combination thereof. In one such embodiment, the nanowires are single-crystalline. For example, for a silicon nanowire 704, a single-crystalline nanowire may be based from a (100) global orientation, e.g., with a <100> plane in the z-direction. As described below, other orientations may also be considered. In an embodiment, the dimensions of the nanowires 704, from a cross-sectional perspective, are on the nano-scale. For example, in a specific embodiment, the smallest dimension of the nanowires 704 is less than approximately 20 nanometers. In an embodiment, the nanowires 704 are composed of a strained material, particularly in the channel regions 706.

Referring to Figures 7C, in an embodiment, each of the channel regions 706 has a width (Wc) and a height (Hc), the width (Wc) approximately the same as the height (Hc). That is, in both cases, the channel regions 706 are square-like or, if corner-rounded, circle-like in cross-section profile. In another aspect, the width and height of the channel region need not be the same, such as the case for nanoribbons as described throughout.

In an embodiment, the structure of Figures 7A-7C can be fabricated to include a low aspect ratio isolation structure and/or a low aspect ratio subfin, such as described above in association with Figures 2, 3A and 3B. In one such embodiment, such an isolation structure has a maximum height and a maximum width with a maximum height to maximum width ratio of less than 3:1. In one such embodiment, such a subfin has a maximum height and a maximum width with a maximum height to maximum width ratio of less than 3:1.

In an embodiment, as described throughout, an integrated circuit structure includes non-planar devices such as, but not limited to, a finFET or a tri-gate device with corresponding one or more overlying nanowire structures. In such an embodiment, a corresponding semiconducting channel region is composed of or is formed in a three-dimensional body with one or more discrete nanowire channel portions overlying the three-dimensional body. In one such embodiment, the gate structures surround at least a top surface and a pair of sidewalls of the three-dimensional body, and further surrounds each of the one or more discrete nanowire channel portions.

In an embodiment, as described throughout, an underlying substrate may be composed of a semiconductor material that can withstand a manufacturing process and in which charge can migrate. In an embodiment, the substrate is a bulk substrate composed of a crystalline silicon, silicon/germanium or germanium layer doped with a charge carrier, such as but not limited to phosphorus, arsenic, boron, gallium or a combination thereof, to form an active region. In one embodiment, the concentration of silicon atoms in a bulk substrate is greater than 97%. In another embodiment, a bulk substrate is composed of an epitaxial layer grown atop a distinct crystalline substrate, e.g. a silicon epitaxial layer grown atop a boron-doped bulk silicon mono-crystalline substrate. A bulk substrate may alternatively be composed of a group III-V material. In an embodiment, a bulk substrate is composed of a group III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, a bulk substrate is composed of a group III-V material and the charge-carrier dopant impurity atoms are ones such as, but not limited to, carbon, silicon, germanium, oxygen, sulfur, selenium or tellurium.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

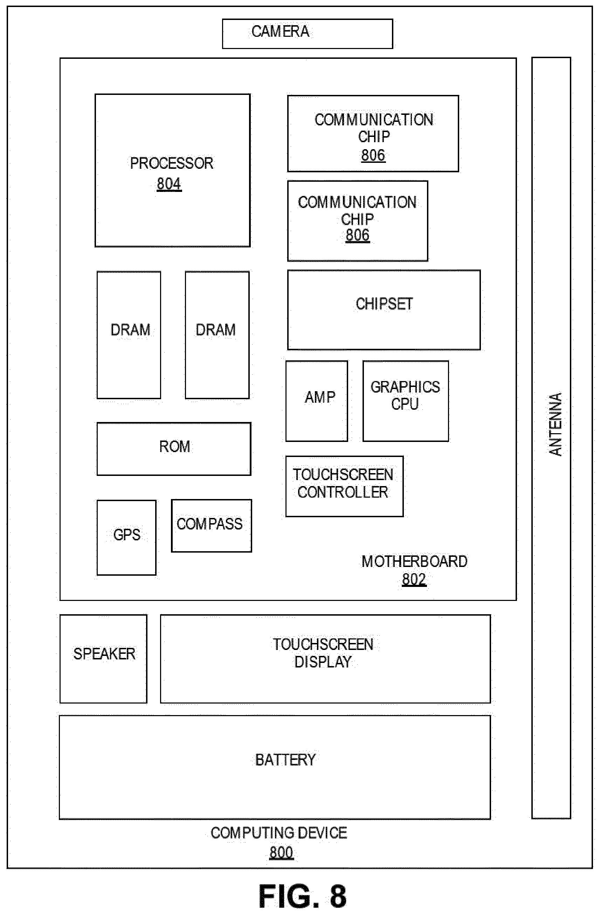

Figure 8 illustrates a computing device 800 in accordance with one implementation of an embodiment of the present disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. The integrated circuit die of the processor 804 may include one or more structures, such as gate-all-around integrated circuit structures having low aspect ratio isolation structures and subfins, built in accordance with implementations of embodiments of the present disclosure. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. The integrated circuit die of the communication chip 806 may include one or more structures, such as gate-all-around integrated circuit structures having low aspect ratio isolation structures and subfins, built in accordance with implementations of embodiments of the present disclosure.

In further implementations, another component housed within the computing device 800 may contain an integrated circuit die that includes one or structures, such as gate-all-around integrated circuit structures having low aspect ratio isolation structures and subfins, built in accordance with implementations of embodiments of the present disclosure.

In various implementations, the computing device 800 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

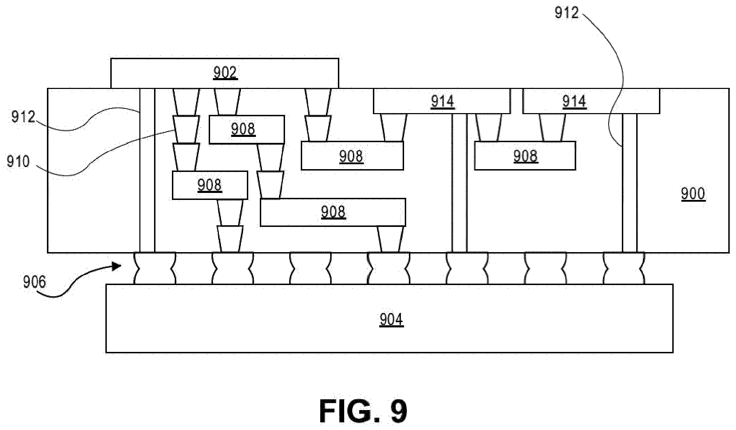

Figure 9 illustrates an interposer 900 that includes one or more embodiments of the present disclosure. The interposer 900 is an intervening substrate used to bridge a first substrate 902 to a second substrate 904. The first substrate 902 may be, for instance, an integrated circuit die. The second substrate 904 may be, for instance, a memory module, a computer motherboard, or another integrated circuit die. Generally, the purpose of an interposer 900 is to spread a connection to a wider pitch or to reroute a connection to a different connection. For example, an interposer 900 may couple an integrated circuit die to a ball grid array (BGA) 906 that can subsequently be coupled to the second substrate 904. In some embodiments, the first and second substrates 902/904 are attached to opposing sides of the interposer 900. In other embodiments, the first and second substrates 902/904 are attached to the same side of the interposer 900. And in further embodiments, three or more substrates are interconnected by way of the interposer 900.

The interposer 900 may be formed of an epoxy resin, a fiberglass-reinforced epoxy resin, a ceramic material, or a polymer material such as polyimide. In further implementations, the interposer 900 may be formed of alternate rigid or flexible materials that may include the same materials described above for use in a semiconductor substrate, such as silicon, germanium, and other group III-V and group IV materials.

The interposer 900 may include metal interconnects 908 and vias 910, including but not limited to through-silicon vias (TSVs) 912. The interposer 900 may further include embedded devices 914, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 900. In accordance with embodiments of the disclosure, apparatuses or processes disclosed herein may be used in the fabrication of interposer 900 or in the fabrication of components included in the interposer 900.

Thus, embodiments of the present disclosure include Gate-all-around integrated circuit structures having low aspect ratio isolation structures and subfins, and method of fabricating gate-all-around integrated circuit structures having low aspect ratio isolation structures and subfins.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.
Example embodiment 1: An integrated circuit structure includes a first vertical arrangement of horizontal nanowires above a first subfin. A second vertical arrangement of horizontal nanowires is above a second subfin laterally adjacent the first subfin. An isolation structure is laterally between the first subfin and the second subfin, the isolation structure having a maximum height and a maximum width with a maximum height to maximum width ratio of less than 3:1.
Example embodiment 2: The integrated circuit structure of example embodiment 1, wherein maximum height to maximum width ratio of the isolation structure is less than 2:1.
Example embodiment 3: The integrated circuit structure of example embodiment 1 or 2, wherein maximum height to maximum width ratio of the isolation structure is less than 1:1.
Example embodiment 4: The integrated circuit structure of example embodiment 1, 2 or 3, wherein each of the first subfin and the second subfin has a maximum height and a maximum width with a maximum height to maximum width ratio of less than 3:1.
Example embodiment 5: The integrated circuit structure of example embodiment 1, 2, 3 or 4, wherein maximum height to maximum width ratio of each of the first subfin and the second subfin is less than 2:1.
Example embodiment 6: The integrated circuit structure of example embodiment 1, 2, 3, 4 or 5, wherein maximum height to maximum width ratio of each of the first subfin and the second subfin is less than 1:1.
Example embodiment 7: The integrated circuit structure of example embodiment 1, 2, 3, 4, 5 or 6, further including a first gate stack over the first vertical arrangement of horizontal nanowires, and a second gate stack over the second vertical arrangement of horizontal nanowires.
Example embodiment 8: The integrated circuit structure of example embodiment 7, further including a first pair of epitaxial source or drain structures at first and second ends of the first vertical arrangement of horizontal nanowires and at first and second sides of the first gate stack, and a second pair of epitaxial source or drain structures at first and second ends of the second vertical arrangement of horizontal nanowires and at first and second sides of the second gate stack.
Example embodiment 9: The integrated circuit structure of example embodiment 8, wherein the first and second pairs of epitaxial source or drain structures are first and second pairs of discrete epitaxial source or drain structures.
Example embodiment 10: The integrated circuit structure of example embodiment 8, wherein the first and second pairs of epitaxial source or drain structures are first and second pairs of non-discrete epitaxial source or drain structures.
Example embodiment 11: The integrated circuit structure of example embodiment 1, 2, 3, 4, 5, 6, 7, 8, 9 or 10, wherein the first and second subfins include a portion of a bulk silicon substrate.
Example embodiment 12: An integrated circuit structure includes a vertical arrangement of horizontal nanowires above a subfin. The subfin has a maximum height and a maximum width with a maximum height to maximum width ratio of less than 3:1. A gate stack is over the vertical arrangement of horizontal nanowires. A pair of epitaxial source or drain structures is at first and second ends of the vertical arrangement of horizontal nanowires and at first and second sides of the gate stack.
Example embodiment 13: The integrated circuit structure of example embodiment 12, wherein maximum height to maximum width ratio of the subfin is less than 2:1.
Example embodiment 14: The integrated circuit structure of example embodiment 12 or 13, wherein maximum height to maximum width ratio of the subfin is less than 1:1.
Example embodiment 15: The integrated circuit structure of example embodiment 12, 13 or 14, wherein the pair of epitaxial source or drain structures is a pair of discrete epitaxial source or drain structures.
Example embodiment 16: The integrated circuit structure of example embodiment 15, wherein the pair of epitaxial source or drain structures is a pair of non-discrete epitaxial source or drain structures.
Example embodiment 17: The integrated circuit structure of example embodiment 15, wherein the subfin includes a portion of a bulk silicon substrate.
Example embodiment 18: A computing device includes a board, and a component coupled to the board. The component includes an integrated circuit structure including a first vertical arrangement of horizontal nanowires above a first subfin. A second vertical arrangement of horizontal nanowires is above a second subfin laterally adjacent the first subfin. An isolation structure is laterally between the first subfin and the second subfin, the isolation structure having a maximum height and a maximum width with a maximum height to maximum width ratio of less than 3:1.
Example embodiment 19: The computing device of example embodiment 18, further including a memory coupled to the board.
Example embodiment 20: The computing device of example embodiment 18 or 19, further including a communication chip coupled to the board.
Example embodiment 21: The computing device of example embodiment 18, 19 or 20, wherein the component is a packaged integrated circuit die.
Example embodiment 22: The computing device of example embodiment 18, 19, 20 or 21, wherein the component is selected from the group consisting of a processor, a communications chip, and a digital signal processor.
Example embodiment 23: The computing device of example embodiment 18, 19, 20, 21 or 22, wherein the computing device is selected from the group consisting of a mobile phone, a laptop, a desk top computer, a server, and a set-top box.

## Claims

1. An integrated circuit structure, comprising:
a first vertical arrangement of horizontal nanowires above a first subfin;
a second vertical arrangement of horizontal nanowires above a second subfin laterally adjacent the first subfin; and
an isolation structure laterally between the first subfin and the second subfin, the isolation structure having a maximum height and a maximum width with a maximum height to maximum width ratio of less than 3:1.

2. The integrated circuit structure of claim 1, wherein maximum height to maximum width ratio of the isolation structure is less than 2:1.

3. The integrated circuit structure of claim 1 or 2, wherein maximum height to maximum width ratio of the isolation structure is less than 1:1.

4. The integrated circuit structure of claim 1, 2 or 3, wherein each of the first subfin and the second subfin has a maximum height and a maximum width with a maximum height to maximum width ratio of less than 3:1.

5. The integrated circuit structure of claim 1, 2, 3 or 4, wherein maximum height to maximum width ratio of each of the first subfin and the second subfin is less than 2:1.

6. The integrated circuit structure of claim 1, 2, 3, 4 or 5, wherein maximum height to maximum width ratio of each of the first subfin and the second subfin is less than 1:1.

7. The integrated circuit structure of claim 1, 2, 3, 4, 5 or 6, further comprising:
a first gate stack over the first vertical arrangement of horizontal nanowires; and
a second gate stack over the second vertical arrangement of horizontal nanowires.

8. The integrated circuit structure of claim 7, further comprising:
a first pair of epitaxial source or drain structures at first and second ends of the first vertical arrangement of horizontal nanowires and at first and second sides of the first gate stack; and
a second pair of epitaxial source or drain structures at first and second ends of the second vertical arrangement of horizontal nanowires and at first and second sides of the second gate stack.

9. The integrated circuit structure of claim 8, wherein the first and second pairs of epitaxial source or drain structures are first and second pairs of discrete epitaxial source or drain structures.

10. The integrated circuit structure of claim 8, wherein the first and second pairs of epitaxial source or drain structures are first and second pairs of non-discrete epitaxial source or drain structures.

11. The integrated circuit structure of claim 1, 2, 3, 4, 5, 6, 7, 8, 9 or 10, wherein the first and second subfins comprise a portion of a bulk silicon substrate.

12. A method of fabricating an integrated circuit structure, the method comprising:
forming a first vertical arrangement of horizontal nanowires above a first subfin;
forming a second vertical arrangement of horizontal nanowires above a second subfin laterally adjacent the first subfin; and
forming an isolation structure laterally between the first subfin and the second subfin, the isolation structure having a maximum height and a maximum width with a maximum height to maximum width ratio of less than 3:1.

13. The method of claim 12, wherein maximum height to maximum width ratio of the isolation structure is less than 2:1.

14. The method of claim 12 or 13, wherein maximum height to maximum width ratio of the isolation structure is less than 1:1.

15. The method of claim 12, 13 or 14, wherein each of the first subfin and the second subfin has a maximum height and a maximum width with a maximum height to maximum width ratio of less than 3:1.
